# EUROPEAN PATENT APPLICATION

(11) **EP 1 616 700 A1**
(43) Date of publication of application: **18.01.2006**
(21) Application number: 05015121.6
(22) Date of filing: 12.07.2005
(51) Int. Cl.: B41J 2/16

(54) **Piezoelectric actuator, ink jet head, and method of manufacturing them**

(30) Priority: 13.07.2004 JP 2004206097; 13.07.2004 JP 2004206077
(71) Applicant: Brother Kogyo Kabushiki Kaisha, Nagoya-shi, Aichi 467-8561 (JP)
(72) Inventor: Yasui, Motohiro c/o Brother Kogyo Kabushiki Kaisha, Nagoya-shi Aichi-ken, 467-8561 (JP)
(74) Representative: Kuhnen & Wacker

(57) **Abstract**

A piezoelectric actuator, an ink jet head, and a method of manufacturing them is presented wherein a manufacturing process can be simplified, costs can be reduced, and operation can be stabilized.

An inner electrode 3 that also functions as a diffusion preventing layer is formed between a metal plate 2 and a piezoelectric layer 4. With this configuration, the layer that functions as both the electrode and the diffusion preventing layer can be formed in a single process, and consequently the manufacturing process can be simplified and manufacturing costs can be reduced. Furthermore, when the electrode and the diffusion preventing layer are a two-layered structure, the materials of these layers combine and strongly influence the bending characteristics of the metal plate. The operation of the piezoelectric actuator can be stabilized by using only one layer that doubles in function as the electrode and as the diffusion preventing layer.

## Description

The present invention relates to a piezoelectric actuator and to an ink jet head that uses this piezoelectric actuator. The present invention further relates to a method of manufacturing the piezoelectric actuator and the ink jet head.

Piezoelectric actuators are utilized for a variety of purposes. A piezoelectric actuator has electrodes formed at a top surface and a bottom surface of a layer (a piezoelectric layer) formed from a material that deforms when voltage is applied between the electrodes at the top surface and the bottom surface of the material. The shape of the piezoelectric layer can be changed by controlling the potential applied between the electrodes on the top surface and the bottom surface. Dividing at least one of the electrodes into a plurality of independent electrodes makes it possible to control the difference in potential applied to each part of the piezoelectric layer.
One of the purposes of piezoelectric actuators is to drive an ink jet head used in an ink jet printer.
Examples of an ink jet head having a piezoelectric actuator integrated therein are taught in Japanese Laid Open Patent Publication H11-314365, Japanese Laid Open Patent Publication H11-334087, and Japanese Laid Open Patent Publication 2000-94681, etc.
The ink jet head is provided with a piezoelectric actuator and a block having ink flow channels formed therein. Ink housing chambers are formed within the block. A plurality of recesses is formed at a top surface of the block, and a plurality of nozzles is formed at a bottom surface of the block. A plurality of ink flow channels is formed in the block. Each of the ink flow channels joins one of the ink housing chambers with one of the recesses, and joins one of the recesses with one of the nozzles.
The piezoelectric actuator is stacked on the top surface of the block provided with the plurality of recesses, and covers this plurality of recesses. The piezoelectric actuator is provided with a piezoelectric layer that deforms when voltage is applied, an outer electrode formed on a top surface of the piezoelectric layer, and an inner electrode formed on a bottom surface of the piezoelectric layer. The piezoelectric actuator is stacked in a state such that the inner electrode is located between the piezoelectric layer and the block. At least one of the outer electrode and the inner electrode is divided into a plurality of independent electrodes. The plurality of independent electrodes can be adjusted independently such that voltage applied to one of the electrodes is not applied to the other of the electrodes. Each of the independent electrodes is formed in a position facing one of the recesses formed in the first surface of the block.
The recesses formed in the top surface of the block form pressure chambers that are sealed by the piezoelectric actuator. When the piezoelectric actuator deforms, volume of the pressure chamber changes. If the piezoelectric actuator deforms so as to enter into the recess, the volume of the pressure chamber is reduced, and ink housed within the pressure chamber is delivered towards the nozzle. When the piezoelectric actuator that had entered the recess returns to a flat state, the volume of the pressure chamber is increased, and ink housed in the ink housing chamber is drawn toward the pressure chamber.

A manufacturing method of the ink jet head exists in which the block and the piezoelectric actuator are formed separately, and the two are then fixed together. This type of manufacturing method is taught in Japanese Laid Open Patent Publication 2000-94681.

A method of manufacturing the block has been developed in which through holes are formed in a plurality of plates, and then these plates having the through holes formed therein are stacked and fixed together. The shape and location of the through holes in the plates is adjusted in advance such that, by stacking these plates and fixing them together, the block can be manufactured that has the ink housing chambers and the plurality of ink flow channels in its interior, and in which the top surface has the plurality of recesses formed thereon, and the bottom surface has the plurality of nozzles formed thereon. Each of the ink flow channels joins one of the ink housing chambers with one of the recesses, and joins one of the recesses with one of the nozzles.
A method of manufacturing the piezoelectric actuator has been developed which continues onwards from the block manufacturing method by continuing the process of stacking the layers. In this technique, a bendable plate is stacked on the top surface of the block provided with the plurality of recesses, thus covering the recesses. An electrode is formed on a top surface of the bendable plate. Thereupon, a piezoelectric layer is stacked on the top surface of the electrode, and finally an electrode is formed on a top surface of the piezoelectric layer. The electrode formed on the top surface of the bendable plate is an inner electrode, and the electrode formed on the top surface of the piezoelectric layer is an outer electrode. At least one of the inner electrode and the outer electrode is divided into a plurality of independent electrodes. Each of the independent electrodes is formed in a location facing one of the recesses formed in the top surface of the block. In this technique, the ink jet head can be manufactured by continuing the process of stacking the layers. Japanese Laid Open Patent Publication H11-314365 and Japanese Laid Open Patent Publication H11-334087 teach a piezoelectric actuator manufacturing method which continues onwards from the block manufacturing method by continuing the process of stacking the layers.

With the piezoelectric actuator manufacturing method which continues onwards from the block manufacturing method by continuing the process of stacking the layers, the manufacturing process is simplified. However, it is now necessary for the piezoelectric layer to undergo a heating process after the piezoelectric layer has been stacked on the top surface of the bendable plate.
In the technique in Japanese Laid Open Patent Publication H11-314365, the bendable plate is formed from SiO₂, the piezoelectric layer is formed on the top surface thereof by the sol-gel method or the sputtering method, and then the heating process is performed.
In the technique in Japanese Laid Open Patent Publication H11-334087, the piezoelectric layer is formed on the top surface of the bendable metal plate by the sol-gel method, the MOD method (the organometallic compound thermal decomposition method), the sputtering method, or the vapor deposition method, and then the heating process is performed.

### Brief Summary of the Invention

Repeated research has shown the present inventors that when the piezoelectric layer is layered on the top surface of the bendable plate by the sol-gel method, the MOD method, the sputtering method, or the vapor deposition method, and the heating process is then performed, the piezoelectric layer contracts during the heating process, thus reducing the performance of the piezoelectric actuator. It was seen that excessive stress is generated between the contracting piezoelectric layer and the bendable plate, and this reduces the performance of the piezoelectric actuator.
A method of forming the piezoelectric layer is taught in Japanese Laid Open Patent Publication 2001-152360. In this method, fine particles that contain piezoelectric material are aerosolized using a carrier gas (being "aerosolized" refers to a state in which the fine particles are suspended in the gas while being separated from other particles), and the aerosolized fine particles are sprayed onto and accumulate on a top surface of a base plate. The accumulated layer is then annealed to form the piezoelectric layer.
The present inventors determined from their research that, for the piezoelectric layer obtained by this method, there is little contraction of the piezoelectric layer during the annealing process, and it should therefore be possible to manufacture a piezoelectric actuator with good performance. The present inventors determined that, in the case of manufacturing the piezoelectric actuator that continues onwards from the block by means of continuing the process of stacking the layers, it should be possible to manufacture an ink jet head with excellent performance by using the method in which the fine particles that contain piezoelectric material are aerosolized and are accumulated, and the accumulated layer is annealed.

However, when this was tested, the performance obtained was not as good as expected. It had been expected that an ink jet head with excellent performance could be manufactured by using the method in which the aerosolized fine particles are accumulated on the top surface of the base plate, and the accumulated layer is annealed. However, this was not the case.

In further research, the present inventors ascertained that, during the process of completing the piezoelectric layer by annealing the layer that had accumulated on the base plate, elements forming the metal plate are diffused into the piezoelectric layer and consequently the performance of the piezoelectric actuator is lowered. That is, a piezoelectric actuator with excellent performance could be manufactured if the elements forming the metal plate could be prevented from diffusing into the piezoelectric layer during the process of completing the piezoelectric layer by annealing the layer that had accumulated on the base plate. The inventors ascertained that if annealing could be performed such that the elements forming the metal plate were prevented from diffusing into the piezoelectric layer, it would be possible to use the advantages of the technique in which aerosolized fine particles are sprayed onto the top surface of the base plate and are accumulated, and a piezoelectric actuator with excellent performance could be manufactured.

In the present invention, a diffusion preventing layer is formed on the top surface of the base plate so as to prevent the elements forming the base from diffusing into the piezoelectric layer during the annealing process. That is, the aerosolized fine particles are accumulated on the base plate that has the diffusion preventing layer formed on its top surface, and are then annealed.
The base plate of the piezoelectric layer fits tightly with the block having the plurality of recesses formed on its top surface, when the base plate is formed from the same metal as the metal from which the block is formed. When the base plate is formed from metal, it can double in function as the inner electrode, and it is not necessarily required to form the inner electrode on the base plate. However, it is useful to form the electrode on the top surface of the base plate, this electrode reducing contact resistance with the piezoelectric layer.
In the present invention, the layer for preventing diffusion is used not only for preventing diffusion, but also as an inner electrode for reducing contact resistance with the piezoelectric layer. That is, an inner electrode in the present invention is formed on the top surface of the base plate that fits tightly with the block (this base plate must be able to bend to fit with the expansion and contraction in volume of the pressure chambers), and the material of this inner electrode is selected from a material that is a conductive material and that also has the function of preventing the diffusion into the piezoelectric layer of the elements forming the metal plate. The fine particles that contain piezoelectric material are accumulated on the top surface of the inner electrode, and the accumulated layer is then annealed.
With this manufacturing method, elements from the base plate are prevented from diffusing into the piezoelectric layer when the accumulated layer is annealed to form the piezoelectric layer, and the performance of the piezoelectric layer can thus be maintained at a high level. Further, there is less contraction of the piezoelectric layer because the annealing is performed after the aerosolized fine particles have been accumulated on the metal base plate, and this reduction in contraction also contributes to maintaining the performance of the piezoelectric layer at a high level. Moreover, since the diffusion preventing layer is also an electrode, contact resistance with the piezoelectric layer is reduced. This reduction in contact resistance also contributes to maintaining the performance of the piezoelectric layer at a high level. With the present invention, these effects are synergistic, and therefore a piezoelectric actuator with excellent performance can be manufactured.
With the present invention, a piezoelectric actuator can be manufactured that displays its usefulness when used together with the ink jet head. However, the piezoelectric actuator that can be manufactured according to the present invention is not limited to being used for the ink jet head. The present invention can also be used for manufacturing a piezoelectric actuator for other uses.

The diffusion preventing layer and the electrode layer can be formed separately. In this case, the diffusion preventing layer is formed between the bendable metal plate and the inner electrode. That is, two layers - the inner electrode and the diffusion preventing layer - are formed between the bendable metal plate and the piezoelectric layer. When two layers are formed between the bendable metal plate and the piezoelectric layer, the materials of the two layers combine and influence the bending characteristics of the metal plate, and consequently it is difficult to stabilize the performance of the piezoelectric layer. In the present invention, the inner electrode and the diffusion preventing layer have been combined into one common component, and therefore this type of problem does not occur.

In the present invention, the inner electrode is formed from a material that is both conductive and can prevent diffusion. As a result, the inner electrode also functions as the diffusion preventing layer. There is no need to provide the inner electrode and the diffusion preventing layer separately, and therefore the manufacturing process can be simplified and manufacturing costs can be reduced. Further, unlike the case where the bending characteristics of the metal plate are easily destabilized by forming the inner electrode and the diffusion preventing layer separately, the bending characteristics of the metal plate are stabilized in the present invention. It is possible, using the present invention, to use the advantage of the method in which the aerosolized fine particles are accumulated on the metal base plate, and the accumulated fine particles are annealed. A piezoelectric actuator with high performance can therefore be manufactured.
Further, in the present invention, the manufacturing process of the piezoelectric actuator can be continued onwards from the manufacturing process of the block having the ink flow channels therein, and the manufacturing processes of the two can thus be streamlined. The positional relationship of the piezoelectric actuator and the block having the ink flow channels therein can also be maintained with a high degree of accuracy.
Furthermore, the piezoelectric actuator is not limited to being used for the ink jet head. That is, a device other than the ink jet head can be manufactured by altering the structure that is formed within the block. In this case, also, there is the advantage that the block and the piezoelectric actuator have an accurate positional relationship.

### Brief Description of the Drawings

FIG. 1 shows a cross-sectional view of an ink jet head of a first representative embodiment.
FIG. 2 shows cross-sectional views showing a manufacturing process of a piezoelectric actuator.
FIG.2 (A) shows a state where a bendable metal plate has been joined with a pressure chamber plate. FIG.2 (B) shows a state where an inner electrode has been formed on the metal plate. FIG.2 (C) shows a state where a piezoelectric layer has been stacked on a top surface of the inner electrode. FIG.2 (D) shows a state where an outer electrode has been formed on a top surface of the piezoelectric layer.
FIG. 3 shows a schematic diagram of a layer forming device.
FIG. 4 shows a cross-sectional view of an ink jet head of a second representative embodiment.

### Detailed Description of the Invention

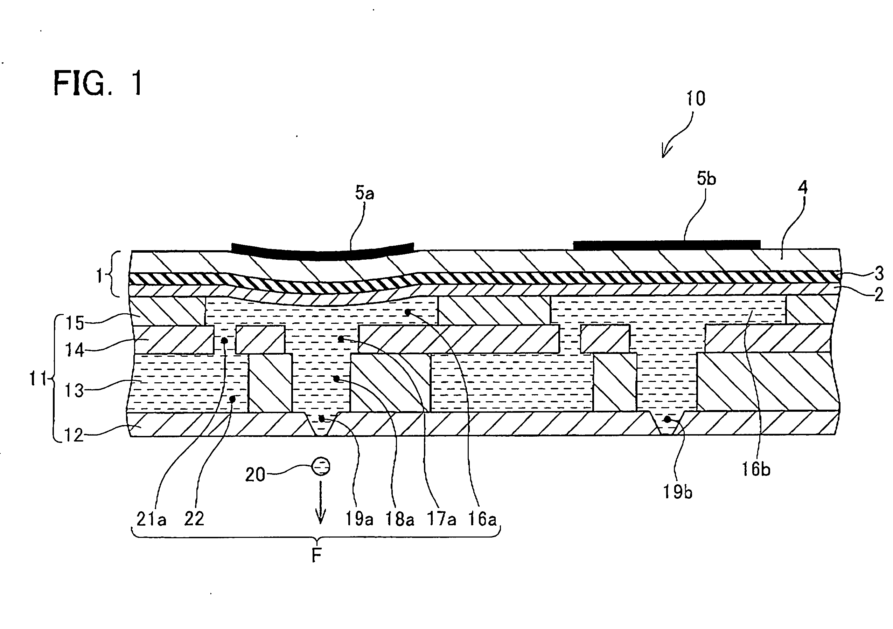

A first representative embodiment of practicing the present invention will be described in detail with reference to FIGS. 1 to 3.
FIG. 1 shows a cross-sectional view of an ink jet head 10 of the first representative embodiment. The ink jet head 10 is provided with a structure in which a block 11 and a piezoelectric actuator 1 are stacked. The lengthwise direction of the block 11 and the piezoelectric actuator 1 is the left-right direction of FIG. 1. FIG. 1 shows only a part of the block 11 and the piezoelectric actuator 1.

The entirety of the block 11 forms a flat plate shape. The block 11 is manufactured by stacking, in sequence, a nozzle plate 12, a manifold plate 13, a flow channel plate 14, and a pressure chamber plate 15, and by joining together the plates 12, 13, 14, and 15 by an epoxy thermosetting adhesive.
The nozzle plate 12 is formed from polyimide synthetic resin. A plurality of through holes passes through the nozzle plate 12, forming a plurality of nozzles 19. Each nozzle 19 discharges ink droplets 20. The plurality of through holes is disposed in a matrix shaped pattern on the nozzle plate 12. In FIG. 1, suffixes a, b, etc. are used to distinguish the nozzles. When the description omits these suffixes a, b, etc., this shows that all the nozzles are being treated as a common unit.
The manifold plate 13 is formed from stainless steel (SUS 430). The manifold plate 13 has a plurality of through holes some of which comprise nozzle flow channels 18 that join with the nozzles 19, and some of which form ink housing chambers 22.
The flow channel plate 14 is also formed from stainless steel (SUS 430). The flow channel plate 14 has a plurality of through holes some of which comprise pressure flow channels 17 that join with the nozzles 19, and some of which form ink intake channels 21 that join with the ink housing chambers 22.
The pressure chamber plate 15 is also formed from stainless steel (SUS 430). The pressure chamber plate 15 has through holes that form pressure chambers 16. The pressure chambers 16 join with the ink housing chambers 22 via the ink intake channels 21, and join with the nozzles 19 via the pressure flow channels 17 and the nozzle flow channels 18.
The plates 12, 13, 14, and 15 that each have the through holes formed therein are stacked and joined together to form the block 11. A plurality of through holes 16 form a plurality of recesses 16 on a top surface of the block 11. A plurality of ink flow channels F are formed within the block 11. Each ink flow channel F joins one of the ink housing chambers 22 with one of the recesses 16, and joins one of the recesses 16 with one of the nozzles 19. For each of the nozzles 19 there is one of these ink flow channels F that connects the nozzle 19 with the ink housing chamber 22 via the ink intake channel 21, the pressure chamber 16, the pressure flow channel 17 and the nozzle flow channel 18. In FIG. 1, the suffixes a, b, etc. are used to show how these components correspond with the nozzles. When the description omits these suffixes a, b, etc., this shows that all the nozzles are being treated as one common unit. The ink housing chamber 22 is a common ink housing chamber for all the nozzles, and therefore does not require suffixes. The ink housing chamber 22 is joined via an ink flow channel (not shown) with an ink cartridge outside the block 11.
The ink flow channels F are extremely narrow, and the through holes 22, 21, 16, 17, 18, and 19 are formed by etching. The plates 13 ~ 15 are formed from metal that is easily etched.

The piezoelectric actuator 1 that is stacked on the block 11 is provided with a bendable metal plate 2 that fits tightly with the top surface of the block 11 and covers the recesses 16, an inner electrode 3 formed on a top surface of the metal plate 2, a piezoelectric layer 4 stacked on a top surface of the inner electrode 3, and an outer electrode 5 formed on a top surface of the piezoelectric layer 4. The outer electrode 5 is divided into a plurality of independent electrodes 5a, 5b, etc.

The bendable metal plate 2 is formed in a rectangular shape from stainless steel (SUS 430), is joined with the top surface of the block 11 by thermo compression bonding, and covers the entirety of the top surface of the block 11. The single metal plate 2 covers the entirety of the recessions 16. The metal plate 2 is formed from the same metal material as the manifold plate 13, the flow channel plate 14, and the pressure chamber plate 15 that comprise the block 11. This allows warping to be prevented when the metal plate 2 is joined by thermocompression bonding to the block 11. The metal plate 2 is moderately thin, and follows the piezoelectric layer 4 in deforming when this piezoelectric layer 4 deforms. If the metal plate 2 deforms so as to enter the recess 16, the volume decreases of the pressure chamber 16. The ink stored within the pressure chamber 16 is delivered towards the nozzle 19, and the ink droplets 20 are discharged from this nozzle 19. When the metal plate 2 that had entered the recesses 16 returns to a flat state, the volume of the pressure chamber 16 is increased. The ink housed in the ink housing chamber 22 is drawn toward the pressure chamber 16.

The inner electrode 3 is formed so as to cover the entirety of the top surface of the metal plate 2. The inner electrode 3 makes direct contact with the metal plate 2, and is connected via the metal plate 2 with a ground of a driver circuit IC (not shown). The inner electrode 3 is fixed to ground voltage. The inner electrode 3 is formed by performing vapor deposition of Au on the top surface of the metal plate 2. The Au is provided, by means of an annealing step to be described later, with the property of preventing elements contained in the metal plate 2 from diffusing into the piezoelectric layer 4, and doubles as a diffusion preventing layer. The inner electrode 3 that is formed from Au decreases contact resistance with the piezoelectric layer 4.

The piezoelectric layer 4 is formed of a piezoelectric ceramic material that is ferroelectric, such as lead zirconate titanate (PZT). The piezoelectric layer 4 is formed in a layer having a thickness that is uniform along the entire top surface of the inner electrode 3. The piezoelectric layer 4 is formed by the aerosol deposition method, and is completed by performing an annealing process and a polarization process.

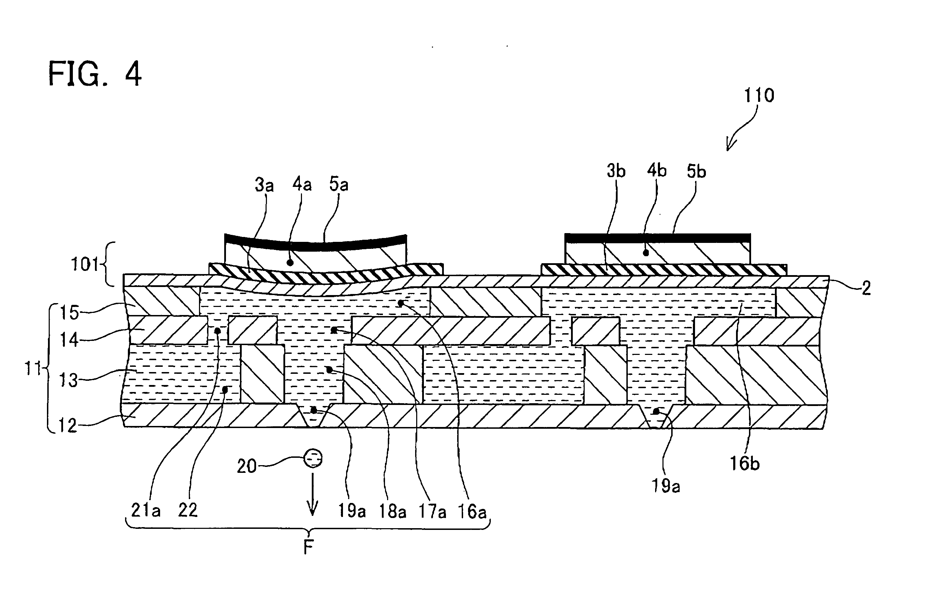

The plurality of independent outer electrodes 5 is provided on the top surface of the piezoelectric layer 4. Each of the independent outer electrodes 5a, 5b, etc. is formed in a position that corresponds to the pressure chambers 16a, 16b, etc. FIG. 4 shows the independent outer electrode 5a formed in a position facing the pressure chamber 16a, and the independent outer electrode 5b formed in a position facing the pressure chamber 16b. Each of the independent outer electrodes 5a, 5b, etc. is connected independently with the driver circuit IC. The driver circuit IC independently controls the independent outer electrodes 5a, 5b, etc. by applying or not applying driving voltage thereto.

The method of manufacturing the ink jet head 10 will now be described. First, the nozzle plate 12 is etched to form the through holes that form the nozzles 19. The manifold plate 13 is etched to form the through holes that form the ink housing chambers 22 and the nozzle flow channels 18. The flow channel plate 14 is etched to form the through holes that form the ink intake channels 21 and the pressure flow channels 17. The pressure chamber plate 15 is etched to form the through holes that form the pressure chambers 16. Next, these plates are bonded together in a stacked state to form the block 11.

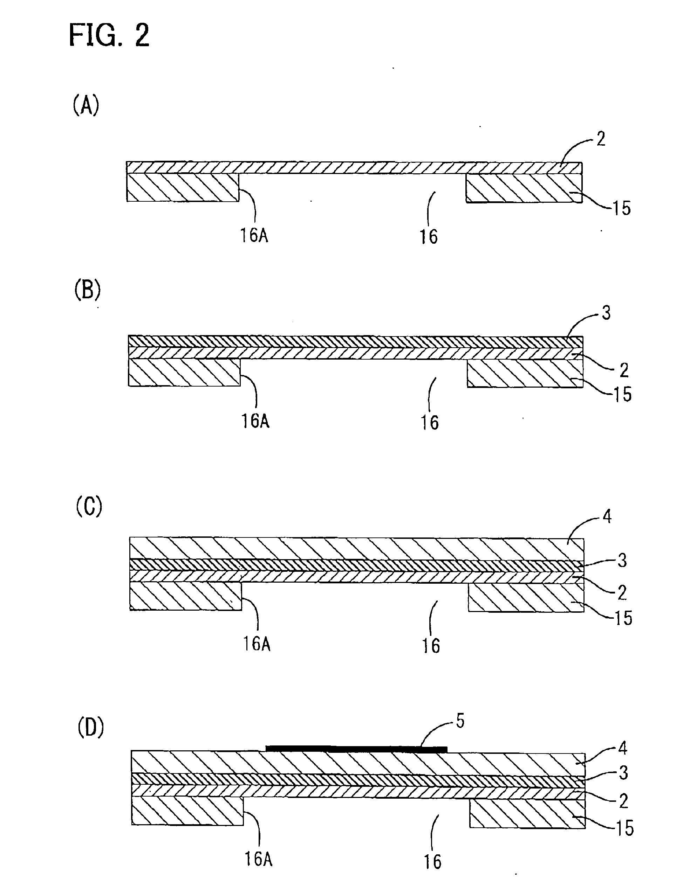

Next, as shown in FIG. 2 (A), the bendable metal plate 2 made from stainless steel is fitted tightly with the top surface of the block 11 and is joined thereto by thermo compression bonding. The pressure chambers 16 are sealed by the metal plate 2.
Next, as shown in FIG. 2 (B), the inner electrode 3 that doubles as the diffusion preventing layer is formed on the top surface of the bendable metal plate 2. The inner electrode 3 can be formed as a thin film by, for example, performing vapor deposition of Au.
Next, as shown in FIG. 2 (C), the piezoelectric layer 4 is formed by means of the aerosol deposition method (the AD method).

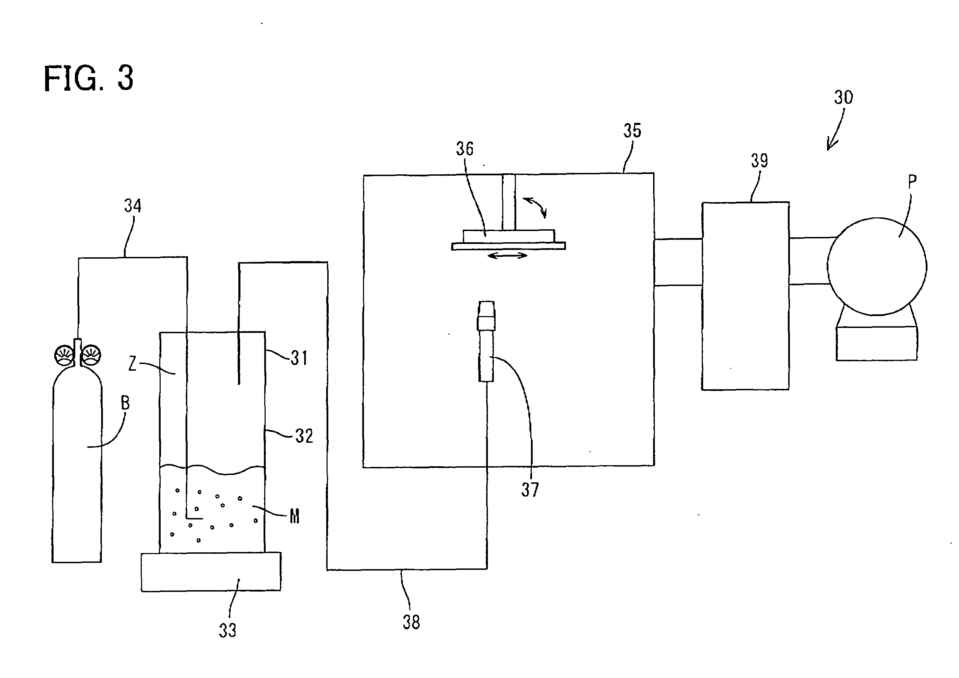

FIG. 3 shows a schematic diagram of a layer forming device 30 for forming the piezoelectric layer 4. The layer forming device 30 is provided with an aerosol generating tool 31 and a layer forming chamber 35. The aerosol generating tool 31 diffuses material particles M in a carrier gas to form an aerosol Z. The layer forming chamber 35 causes the aerosol Z to be sprayed from a spray nozzle 37 and adhere to (accumulate on) the metal plate 2.

The aerosol generating tool 31 is provided with an aerosol chamber 32 capable of housing the material particles M, and a shaker 33 that can be attached to the aerosol chamber 32. The shaker 33 shakes the aerosol chamber 32. A gas cylinder B is connected with the aerosol chamber 32. This gas cylinder B introduces the carrier gas via an introducing tube 34. A tip of the introducing tube 34 is located at the vicinity of a base face within the aerosol chamber 32, and is submerged in the material particles M. The carrier gas can be, for example, an inert gas such as helium, argon, nitrogen, etc., or air, oxygen, etc.

The layer forming chamber 35 is provided with a stage 36 and the spray nozzle 37. The block 11 and the metal plate 2 fixed thereto are attached to the stage 36. The spray nozzle 37 is formed below the stage 36. The spray nozzle 37 is connected with the aerosol chamber 32 via an aerosol supply tube 38. The aerosol Z in the aerosol chamber 32 passes through the aerosol supply tube 38 and is supplied to the spray nozzle 37. A vacuum pump P is connected with the layer forming chamber 35 via a powder recovery device 39, thus realizing a configuration in which pressure within the layer forming chamber 35 can be reduced.

When the piezoelectric layer 4 is to be formed using the layer forming device 30, the block 11 having the metal plate 2 fixed thereto is set such that the metal plate 2 is face downwards. Next, the material particles M are introduced into the aerosol chamber 32. Material that displays piezoelectric effects, such as for example lead zirconate titanate (PZT), can be used for the material particles M.

Next, the carrier gas is introduced from the gas cylinder B, and the gas pressure of the carrier gas causes the material particles M to rise. Simultaneously, the shaker 33 shakes the aerosol chamber 32, thus mixing the material particles M and the carrier gas, and forming the aerosol Z. Thereupon, the pressure within the layer forming chamber 35 is reduced by the vacuum pump P. This causes a difference in pressure between the aerosol chamber 32 and the layer forming chamber 35. The pressure difference causes the aerosol Z in the aerosol chamber 32 to be sprayed with a high velocity from the spray nozzle 37. The material particles M contained in the aerosol Z that is being sprayed collide with and accumulate on the metal plate 2, thus forming the piezoelectric layer 4.

Next, the piezoelectric layer 4 that has been formed is annealed so as to obtain necessary piezoelectric characteristics. At this juncture, the inner electrode 3 that doubles in function as the diffusion preventing layer is formed along an entire plane between the piezoelectric layer 4 and the metal plate 2. Consequently, metal elements such as Fe, etc. contained in the bendable metal plate 2 are prevented from being diffused into the piezoelectric layer 4.

Next, as shown in FIG. 2 (D), the plurality of independent outer electrodes 5a, 5b, etc. are formed on the top surface of the piezoelectric layer 4. To form the plurality of independent outer electrodes 5a, 5b, etc. a conductive film can be formed across the entire range of the piezoelectric layer 4. Then, the independent outer electrodes 5a, 5b, etc. can be formed by, for example, using photo lithographic etching to form a predetermined pattern or, alternatively, by screen printing directly onto the top surface of the piezoelectric layer 4.

Then, an electric field is applied between the independent outer electrodes 5a, 5b, etc. and the inner electrode 3. This electric field is stronger than is normal during an ink discharging operation. As a result, the piezoelectric layer 4 is polarized in its direction of thickness between the two electrodes. The piezoelectric actuator 1 and the ink jet head 10 are thus completed.

Next, the operation and effects of the ink jet head 10 configured as described above will be described.
When printing is to be performed, the independent outer electrodes to which voltage will be applied are selected in accordance with the pattern to be printed. A predetermined driving signal from the driver circuit IC is applied to the selected independent outer electrodes, and when a high voltage is applied to the selected independent outer electrodes, an electric field is applied to the piezoelectric layer 4 in its direction of polarization (its direction of thickness). Thereupon, locations of the piezoelectric layer 4 that correspond to the selected independent outer electrodes expand in the direction of thickness while contracting in a planar direction. The piezoelectric layer 4 and the metal plate 2 thus deform at the locations that correspond to the selected independent outer electrodes so as to protrude into the recesses 16 (unimorph deformation). The capacity of the pressure chambers 16 is thus reduced, the pressure of the ink 20 is increased, and the ink 20 is sprayed from the nozzles 19. Thereupon, the outer electrodes 5 are returned to having identical potential with the inner electrode 3, and the piezoelectric layer 4 and the metal plate 2 return to their original shape. The capacity of the pressure chambers 16 increases, thus causing the ink 20 to be drawn from the ink housing chamber 22.

If two layers - the diffusion preventing layer and the inner electrode- are located between the metal plate 2 and the piezoelectric layer 4, the materials of the two layers combine and influence the bending characteristics of the metal plate 2. It is therefore difficult to stabilize the bending operation. However, in the ink jet head 10 of the first embodiment, the inner electrode 3 also functions as the diffusion preventing layer and consequently there is only a single layer between the metal plate 2 and the piezoelectric layer 4. As a result, the effects of the material of the inner electrode 3 (which doubles as the diffusion preventing layer) on the bending characteristics of the metal plate 2 can be kept to a minimum, and the operation of the piezoelectric actuator 1 can therefore be stabilized.

The inner electrode 3 that doubles as the diffusion preventing layer is thus formed between the metal plate 2 and the piezoelectric layer 4 in the first embodiment. According to this configuration, the layer that functions as both the electrode and the diffusion preventing layer can be formed in one process, and consequently the manufacturing process can be simplified and manufacturing costs can be reduced.

Further detail relating to the present invention will be given below with reference to experiments.

### <Experiment 1>

1) layer formation process
The inner electrode 3 consisting of Pt was formed by sputtering on the top surface of the metal plate 2 formed from stainless steel (SUS 430). The thickness of the inner electrode measured by a surface roughness meter was approximately 1.5 µm. Then the metal plate 2 with the inner electrode 3 was set in the device as shown in FIG. 3.
Fine particles of PZT with an average particle diameter of 0.3 ~ 1 µm were used. Opening of the nozzle 37 was 0.4 x 10 mm. The pressure in the layer forming chamber was 200 Pa. The pressure in the aerosol chamber was 30000 Pa. The carrier gas was He. Gas flow quantity was 4.0 liters/min. The distance between the nozzle 37 and the metal plate 2 was 10 ~ 20 mm. The piezoelectric layer 4 was formed by blowing the aerosol. The thickness of the piezoelectric layer 4 measured by a surface roughness meter was approximately 8 µm.

2) annealing process
The annealing process was performed of the piezoelectric layer that had been formed. The metal plate 2 having the piezoelectric layer 4 formed thereon was placed in a muffle furnace (Yamato Scientific Co., Ltd. FP 100). Temperature was raised to 850°C at 300°C/h. The temperature of 850°C was maintained for 30 minutes, then the temperature of the furnace was reduced to room temperature by means of self cooling. The metal plate 2 was then taken out.

2. Experiments
Masking was performed using adhesive resin tape on the piezoelectric layer. Au vapor deposition was performed to form an outer electrode having a significant area of more than 3.6 mm². The polarization process was then performed using an electric field of 318 kV/cm. This completed the manufacture of the piezoelectric actuator.
Capacitance of this piezoelectric actuator was measured, while applying voltage, by means of a ferroelectric tester (TF ANALYZER 2000; Aixacht Technologies). Remnant polarization (Pr) and coercive electric field (Ec) were measured.

<Comparison 1>
A piezoelectric layer was formed that was identical with that of embodiment 1, with the exception that the inner electrode 3 was not formed, and testing was performed. The applied electric field was 400 kV/cm.

<Comparison 2>
An alumina plate was used instead of a metal plate 2. An inner electrode was formed by forming a paste layer with a thickness of 8 µm on the alumina plate using Pt paste (Tanaka Kikinzoku Kogyo), and by baking at 1300°C.
A piezoelectric layer formed by the same method as in embodiment 1 was formed on the alumina plate having the inner electrode formed thereon, and testing was performed. The applied electric field was 329 kV/cm.

<Comparison 3>
An alumina plate was used instead of a metal plate. An inner electrode was formed by forming a paste layer with a thickness of 8 µm on the alumina plate using Au paste (Tanaka Kikinzoku Kogyo; TR 1533), and by baking at 850°C.
A piezoelectric layer formed by the same method as in embodiment 1 was formed on the alumina plate having the inner electrode performed thereon, and testing was performed. The applied electric field was 286 kV/cm.

[Results and Observations]
The results of the embodiment and the comparisons are shown in the following table.

| Base plate | Lower electrode | Annealing Temp(°C) | min. | Electric field kV/cm | Pr *µ* C/cm² | Ec kV/cm | Pr/Ec |
|---|---|---|---|---|---|---|---|
| SUS430 | Pt | 850 | 30 | 318 | 24.9 | 51.7 | 0.48 |
| SUS430 | - | 850 | 30 | 400 | 22.4 | 220 | 0.10 |
| Al₂O₃ | Pt | 850 | 30 | 329 | 24.5 | 60.0 | 0.41 |
| Al₂O₃ | Au | 850 | 30 | 286 | 26.7 | 49.8 | 0.54 |

Almost identical piezoelectric characteristics were displayed in the case (embodiment 1) where the inner electrode 3 was formed from Pt on the base plate 2 made from stainless steel (SUS 430), and in the case (Comparisons 2 and 3) where the alumina plate was used that does not diffuse elements into the piezoelectric layer 4. By contrast, in the case (Comparison 1) where the inner electrode 3 was not formed on the stainless steel plate 2, the Fe elements or Cr elements contained in the stainless steel plate 2 were diffused into the piezoelectric layer 4, the coercive electric field of the piezoelectric layer 4 increased, and the Pr/Ec was greatly reduced. It was ascertained from this that the Fe elements or Cr elements contained in the stainless steel plate 2 can be prevented from diffusing into the piezoelectric layer 4 by forming the inner electrode 3 on the stainless steel plate 2.

Next, a second embodiment will be described in detail with reference to FIG. 4. Below, only points differing from the first embodiment will be described.
As is clear from FIG. 4, the inner electrode 3 is not one common electrode in the second embodiment, but is instead divided into a plurality of independent inner electrodes 3a, 3b, etc. Each of the independent inner electrodes 3 is formed in a position that corresponds to one of each of the pressure chambers 16. FIG. 4 shows the independent inner electrode 3a formed in a position facing the pressure chamber 16a, and the independent inner electrode 3b formed in a position facing the pressure chamber 16b. Each of the independent inner electrodes 3a, 3b, etc. is connected independently with the driver circuit IC. The driver circuit IC independently controls the independent inner electrodes 3a, 3b, etc. by applying or not applying driving voltage thereto.
In the second embodiment, the piezoelectric layer 4 is also divided into a plurality of independent piezoelectric layers 4a, 4b, etc. Each of the independent piezoelectric layers 4 is formed in a position that corresponds to one of each of the pressure chambers 16. FIG. 4 shows the independent piezoelectric layer 4a formed in a position facing the pressure chamber 16a, and the independent piezoelectric layer 4b formed in a position facing the pressure chamber 16b. The independent piezoelectric layers 4a, 4b, etc. are stacked on the top surfaces of the independent inner electrodes 3a, 3b, etc. When viewed from a direction perpendicular to the metal plate 2, each of the independent piezoelectric layers 4a, 4b, etc. is encompassed within each of the independent inner electrodes 3a, 3b, etc. More precisely, each of the independent piezoelectric layers 4a, 4b, etc. is offset inwards by 20 µm (equivalent to the thickness of the independent piezoelectric layers 4a, 4b, etc. in the second embodiment) from the independent inner electrodes 3a, 3b, etc. When the independent piezoelectric layers 4a, 4b, etc. are encompassed within the independent inner electrodes 3a, 3b, etc. while being offset inwards therefrom by at least a distance equivalent to the thickness of the independent piezoelectric layers 4a, 4b, etc., it is possible to prevent the elements in the metal plate 2 from being diffused into the independent piezoelectric layers 4a, 4b, etc. in spite of diffusion occurring in the horizontal direction of FIG. 4. It was understood from experiments that it is preferred to offset the border of the independent piezoelectric layers 4a, 4b, etc. inwards by 20 µm ~ 500 µm from the border of the independent inner electrodes 3a, 3b, etc. If the independent piezoelectric layers 4a, 4b, etc. are offset inwards by a distance of equal to or more than the 20 µm that is equivalent to their thickness, the diffusion of the elements from the metal plate 2 into the independent piezoelectric layers 4a, 4b, etc. can be prevented, and if the distance is below 500 µm, the area required by the independent piezoelectric layers 4a, 4b, etc. can be maintained.
In the second embodiment, the outer electrode 5 is also divided into the plurality of independent outer electrodes 5a, 5b, etc.
In the second embodiment, the driver circuit IC independently controls the independent inner electrodes 3a, 3b, etc. by applying or not applying driving voltage thereto. Further, the driver circuit IC independently controls the independent outer electrodes 5a, 5b, etc. by applying or not applying driving voltage thereto. However, the independent outer electrodes 5a, 5b, etc. may instead be maintained at a common potential. In that case, a single common outer electrode 5 may be formed instead of dividing the outer electrode 5 into the plurality of independent outer electrodes 5a, 5b, etc.

In the second embodiment, the piezoelectric layer 4 is divided into the independent piezoelectric layers 4a, 4b, etc., and space is formed between these independent piezoelectric layers 4a, 4b, etc. However, a single common piezoelectric layer 4 may instead be used. In that case, the elements from the stainless steel plate 2 are diffused into the portions of the piezoelectric layer 4 that are located above the spaces between the independent inner electrodes 3a, 3b, etc. and reduce the piezoelectric characteristics of those portions. However, piezoelectric effects are not required in the portions of the piezoelectric layer located above the spaces between the independent inner electrodes 3a, 3b, etc. Therefore, this is no particular problem.

The inner electrode of the present invention may be any material that is conductive and that can prevent the elements contained in the metal plate from being diffused. For example, in the case where the element contained in the metal plate is iron, aluminum, chrome, cobalt, manganese, molybdenum, or tungsten, it is preferred that the material of the inner electrode is one element or two or more elements selected from among: Au, Pt, Ti, Ag-Pd alloy, Ag-Pt alloy, Rh, In, La, Nd, Nb, Sb, Th, W, Ca, Sr, Mg, or an oxide of these. For example, a thin metal layer may be formed from any of the aforementioned elements, or from a thin layer of an oxide of the aforementioned elements. It is preferred that the following are used for the thin layer of oxide: La₁₋ₓSrₓMnO₃ (LSMO), (La₁₋ₓSrₓ) (Ga_{1-y}Mg_{y}) O_{3-δ} (LSGM), indium tin oxide (ITO), SrRuO₃ (SRO), La₂₋ₓSrₓCoO₄ (LSCO), etc.

It is preferred that the thickness of the inner electrode is equal to or above 0.1 µm and equal to or below 5 µm. By having the thickness equal to or above 0.1 µm, the diffusion of the elements from the metal plate to the piezoelectric layer can be intercepted adequately. Further, by having the thickness equal to or below 5 µm, the influence from the bending of the metal plate can be restricted such that it does not influence the operation of the piezoelectric actuator.

The piezoelectric actuator of the present invention is particularly useful when used while stacked on the block that was manufactured by stacking the plurality of metal plates so as to realize the extremely narrow ink flow channels. The piezoelectric actuator and the block are joined strongly together by forming the piezoelectric layer on the metal plates that are formed from an identical type of metal that has a similar coefficient of thermal expansion as the block.

It is preferred that the inner electrode is a common electrode that is used for the plurality of pressure chambers. However, as shown in FIG. 4, the inner electrode may also be divided into a plurality of independent inner electrodes. Each of the independent inner electrodes prevents elements that form the metal layer from diffusing into the independent piezoelectric layers stacked above the independent inner electrodes. It is preferred that, to deal with horizontal diffusion, the independent inner electrodes project sideways for a distance greater than the layer thickness of the independent piezoelectric layers. By having the independent inner electrodes project sideways for a distance greater than the layer thickness of the independent piezoelectric layers, it is possible to prevent the elements that form the metal layer from diffusing into the independent piezoelectric layers even if these elements are diffusing in a horizontal direction.

In the case, also, where a common piezoelectric layer and a common inner electrode are used, it is preferred that the common inner electrode projects outwards for a distance equal to or greater than the thickness of the layer thickness of the common piezoelectric layer so as to prevent a reduction in piezoelectric performance of the piezoelectric layer in the area near its boundary. It is possible to prevent the elements that form the metal layer from diffusing into the piezoelectric layer even if the elements are diffusing in a horizontal direction.

The technical scope of the present invention is not restricted to the embodiments described above. For example, the examples taught below are also encompassed in the technical scope of the present invention. In addition, the technical scope of the present invention extends to an equivalent of the claimed elements.
(1) In the aforementioned embodiments, the inner electrode 3 is formed by the vapor deposition method. However, the method for forming the inner electrode is not limited to the method in the aforementioned embodiment. Instead, the inner electrode may be formed using a method by which electrodes are normally formed, such as sputtering, plating, coating, baking after printing a conductive paste, etc.
(2) In the aforementioned embodiments, the plates 13, 14, and 15 that form the block 11, as well as the metal plate 2, were formed from stainless steel (SUS 430). However, the material of the block and the metal plates is not limited to the material in the aforementioned embodiment. For example, the block and the metal plates may also be formed from, for example, SUS 304, 42A alloy, etc.

## Claims

1. A piezoelectric actuator comprising:
a bendable metal plate;
an inner electrode formed on a top surface of the metal plate;
a piezoelectric layer stacked on a top surface of the inner electrode, the piezoelectric layer being deformed when voltage is applied to the piezoelectric layer; and
an outer electrode formed on a top surface of the piezoelectric layer;
wherein the piezoelectric layer is made of an annealed accumulated layer of fine particles containing piezoelectric material, and the inner electrode is made of a material capable of preventing the elements forming the metal plate from diffusing into the piezoelectric layer.

2. A piezoelectric actuator of claim 1:
wherein the metal plate contains al least one element selected from a group consisting of iron, aluminum, chrome, cobalt, manganese, molybdenum, and tungsten, and
the inner electrode contains al least one element selected from a group consisting of Au, Pt, Ti, Ag-Pd alloy, Ag-Pt alloy, Rh, In, La, Nd, Nb, Sb, Th, W, Ca, Sr, Mg, and an oxide of these.

3. A piezoelectric actuator of claim 2:
wherein the inner electrode contains al least one element selected from a group consisting of La₁₋ₓSrₓMnO₃ (LSMO), (La₁₋ₓSrₓ) (Ga_{1-y}Mg_{y}) O_{3-δ} (LSGM), indium tin oxide (ITO), SrRuO₃ (SRO), and La₂₋ₓSrₓCoO₄ (LSCO).

4. A piezoelectric actuator of claim 1:
wherein thickness of the inner electrode is equal to or above 0.1 µm and equal to or below 5 µm.

5. A piezoelectric actuator of claim 1:
wherein a plurality of independent inner electrodes is formed on the top surface of the metal plate, the piezoelectric layer comprises a plurality of independent piezoelectric layers, each of the independent piezoelectric layers is stacked on the top surface of each of the independent inner electrodes, and each of the independent piezoelectric layers is encompassed within each of the independent inner electrodes when viewed from a direction perpendicular to the metal plate.

6. A piezoelectric actuator of claim 5:
wherein, when viewed from a direction perpendicular to the metal plate, each of the independent piezoelectric layers is encompassed within each of the independent inner electrodes while being offset inwards from the independent inner electrodes by a distance equivalent to the thickness of the independent piezoelectric layers.

7. An ink jet head comprising:
a block having ink flow passages within the block, the block being formed by stacking and fixing a plurality of plates having holes penetrating each plate, and a plurality of recesses consisting of holes formed on the uppermost plate being formed at a top surface of the block;
a bendable metal plate stacked on the top surface of the block to seal the plurality of recesses, the metal plate being formed from the same type of metal forming the block;
an inner electrode formed on a top surface of the metal plate;
a piezoelectric layer stacked on a top surface of the inner electrode, the piezoelectric layer being deformed when voltage is applied to the piezoelectric layer; and
an outer electrode formed on a top surface of the piezoelectric layer;
wherein the piezoelectric layer is formed from an annealed accumulated layer of fine particles containing piezoelectric material, and the inner electrode is formed from a material capable of preventing the elements forming the metal plate from diffusing into the piezoelectric layer.

8. An ink jet head of claim 7,
wherein the inner electrode has a size large enough to cover the plurality of recesses, and the outer electrode comprises a plurality of independent outer electrodes, each of the independent outer electrodes being formed at a location opposing one of each of the recesses.

9. An ink jet head of claim 7,
wherein the inner electrode comprises a plurality of independent inner electrodes, each of the independent inner electrodes being formed at a location opposing each of the recesses formed in the top surface of the block, and
the piezoelectric layer comprises a plurality of independent piezoelectric layers, each of the independent piezoelectric layers being stacked on a top surface of each of the independent inner electrodes, and each of the independent piezoelectric layers being encompassed within each of the independent inner electrodes when viewed from a direction perpendicular to the metal plate.

10. An ink jet head of claim 9,
wherein, when viewed from a direction perpendicular to the metal plate, each of the independent piezoelectric layers is encompassed within each of the independent inner electrodes while being offset inwards from the independent inner electrodes by a distance equivalent to the thickness of the independent piezoelectric layers.

11. A method of manufacturing a piezoelectric actuator having stacked thereon a bendable metal plate, an inner electrode, a piezoelectric layer, and an outer electrode, the method comprising:
a step of forming the inner electrode on a top surface of the metal plate;
a step of forming the piezoelectric layer on a top surface of the inner electrode, this piezoelectric layer being deformed when voltage is applied to the piezoelectric layer; and
a step of forming the outer electrode on a top surface of the piezoelectric layer;
wherein the step of forming the piezoelectric layer comprises a step of accumulating a layer of fine particles containing piezoelectric material on the top surface of the inner electrode, and a step of annealing the accumulated layer, and
in the step of forming the inner electrode, a material capable of preventing elements forming the metal plate from diffusing into the piezoelectric layer is selected, and the inner electrode is formed therefrom.

12. A method of manufacturing the piezoelectric actuator of claim 11:
wherein the metal plate contains at least one element selected from a group consisting of iron, aluminum, chrome, cobalt, manganese, molybdenum, and tungsten; and
the inner electrode contains at least one element selected from a group consisting of Au, Pt, Ti, Ag-Pd alloy, Ag-Pt alloy, Rh, In, La, Nd, Nb, Sb, Th, W, Ca, Sr, Mg, and an oxide of these.

13. A method of manufacturing the piezoelectric actuator of claim 12:
wherein the inner electrode contains at least one oxide selected from a group consisting of La₁₋ₓSrₓMnO₃ (LSMO), (La₁₋ₓSrₓ) (Ga_{1-y}Mg_{y}) O_{3-δ} (LSGM), indium tin oxide (ITO), SrRuO₃ (SRO), and La₂₋ₓSrₓCoO₄ (LSCO).

14. A method of manufacturing the piezoelectric actuator of claim 11:
wherein thickness of the inner electrode is equal to or above 0.1 µm and equal to or below 5 µm.

15. A method of manufacturing a piezoelectric actuator of claim 11:
wherein in the step of forming the inner electrode, a plurality of independent inner electrodes is formed on the top surface of the metal plate;
in the step of forming the piezoelectric layer, a plurality of independent piezoelectric layers is formed; and
each of the independent piezoelectric layers is stacked on the top surface of each of the independent inner electrodes, each of the independent piezoelectric layers being encompassed within each of the independent inner electrodes when viewed from a direction perpendicular to the metal plate.

16. A method of manufacturing the piezoelectric actuator of claim 15:
wherein, when viewed from a direction perpendicular to the metal plate, each of the independent piezoelectric layers is encompassed within each of the independent inner electrodes while being offset inwards from the independent inner electrodes by a distance equivalent to the thickness of the independent piezoelectric layers.

17. A method of manufacturing an ink jet head comprising a block having ink flow passages within the block, and a piezoelectric actuator having stacked thereon a bendable metal plate, an inner electrode, a piezoelectric layer, and an outer electrode, the method comprising:
a step of forming holes penetrating the plurality of plates;
a step of forming the block by stacking and fixing the plurality of plates;
a step of stacking and fixing the bendable metal plate on the top surface of the block, the metal plate being formed from the same type of metal forming the block;
a step of forming the inner electrode on a top surface of the metal plate;
a step of forming the piezoelectric layer on a top surface of the inner electrode, the piezoelectric layer being deformed when voltage is applied to the piezoelectric layer; and
a step of forming the outer electrode on a top surface of the piezoelectric layer;
wherein the step of forming the piezoelectric layer comprises a step of accumulating fine particles containing piezoelectric material on the top surface of the inner electrode, and a step of annealing this accumulated layer, and
a material capable of preventing elements forming the metal plate from diffusing into the piezoelectric layer is selected in the step of forming the inner electrode.

18. A method of manufacturing the ink jet head of claim 17:
wherein the inner electrode has a size large enough to cover a plurality of recesses formed on a top surface of the block, and the outer electrode comprises a plurality of independent outer electrodes, each of the independent outer electrodes being formed at a location opposing one of each of the recesses.

19. A method of manufacturing the ink jet head of claim 17:
wherein the inner electrode comprises a plurality of independent inner electrodes, each of the independent inner electrodes being formed at a location opposing each of the recesses formed in the top surface of the block, and
the piezoelectric comprises a plurality of independent piezoelectric layers, each of the independent piezoelectric layers being stacked on a top surface of each of the independent inner electrodes, and each of the independent piezoelectric layers being encompassed within each of the independent inner electrodes when viewed from a direction perpendicular to the metal plate.

20. A method of manufacturing the ink jet head of claim 19:
wherein, when viewed from a direction perpendicular to the metal plate, each of the independent piezoelectric layers is encompassed within each of the independent inner electrodes while being offset inwards from the independent inner electrodes by a distance equivalent to the thickness of the independent piezoelectric layers.
